# FASCICULE DE BREVET EUROPEEN

(11) **EP 4 154 309 B1**
(45) Date de publication et mention de la délivrance du brevet: **03.07.2024**
(21) Numéro de dépôt: 21726137.9
(22) Date de dépôt: 20.05.2021
(51) Int. Cl.: H01L 23/498, G06K 19/077

(54) **CIRCUIT ELECTRIQUE POUR MODULE ELECTRONIQUE DE CARTE A PUCE AVEC DES CONTACTS DE COULEUR ET SON PROCEDE DE REALISATION**
ELEKTRISCHE SCHALTUNG FÜR EIN ELEKTRONISCHES CHIPKARTENMODUL MIT FARBIGEN KONTAKTEN UND VERFAHREN ZU DEREN HERSTELLUNG
ELECTRIC CIRCUIT FOR AN ELECTRONIC CHIP CARD MODULE WITH COLOURED CONTACTS AND METHOD FOR PRODUCING SAME

(30) Priorité: 21.05.2020 FR 2005396
(43) Date de publication de la demande: 29.03.2023
(73) Titulaire: Linxens Holding, 78200 Mantes-la-Jolie (FR)
(72) Inventeur: VASSAL, Simon, 78200 MANTES-LA-JOLIE (FR); RAMSAMY, Catheline, 78200 MANTES-LA-JOLIE (FR); GREMION, François, 78200 MANTES-LA-JOLIE (FR); MICHAUDET, Nicolas, 78200 MANTES-LA-JOLIE (FR)
(74) Mandataire: INNOV-GROUP
(86) Numéro de dépôt international: PCT/EP2021/063535
(87) Numéro de publication internationale: WO 2021/234118

(56) Documents cités:
- WO-A1-2014/064278
- FR-A1- 3 074 193
- US-B1- 6 259 035

## Description

### Domaine technique

L'invention concerne le domaine des circuits électriques comportant des contacts ou des pistes conductrices de connecteurs.

### Etat de la technique

Dans ce document, un exemple d'application du circuit électrique selon l'invention est pris dans le domaine de la carte à puce, mais cet exemple est aisément transposable à d'autres applications des circuits électriques. Notamment, l'invention est particulièrement intéressante dans tous les cas où les pistes conductrices sont visibles sur le produit fini, tel qu'utilisé par un consommateur. Par exemple, la réalisation de contacts de couleur pour des connecteurs de cartes mémoires SD ou de clés USB peut aussi apporter une plus-value esthétique.

Une carte à puce comporte un module électronique avec des plages de contacts électriques -ou connecteur- pour la connexion et la communication, d'au moins une puce électronique attachée au module, avec un système de lecture/écriture.

En effet, une carte à puce est généralement constituée d'un support relativement rigide, par exemple en matière plastique, constituant l'essentiel de la carte, dans lequel est incorporé un module électronique fabriqué séparément. Ce module électronique comporte un circuit imprimé généralement flexible muni d'une puce électronique (circuit intégré) et de moyens de connexion -ou connecteur- constitués par exemple de contacts formés de pistes métalliques conductrices affleurant sur le module électronique, en surface du support.

Les cartes à puce ont de multiples usages : cartes de crédit, cartes SIM pour téléphones portables, cartes de transport, cartes d'identité, etc.

Alors, outre la nécessité d'avoir une bonne conduction électrique entre les contacts et le connecteur d'un dispositif de lecture/écriture, les fabricants de cartes à puce souhaitent assortir la couleur des contacts à la ou les couleurs(s) de la carte. A cet effet, les contacts sont généralement recouverts soit d'une couche d'or, pour obtenir une finition dorée, soit d'une couche d'argent ou de palladium, pour obtenir une finition argentée.

Pour obtenir plus de couleurs, il est possible d'utiliser un procédé tel que décrit dans le document US6259035B1. Ce procédé repose sur l'utilisation de solutions à base d'or, de palladium ou d'argent pour obtenir un plus large spectre de couleurs. Le document FR 3 074 193 A1 décrit un procédé pour obtenir une couleur blanche ou tirant sur le blanc. Cependant ce type de procédé ne permet pas d'obtenir certaines couleurs et notamment une couleur noire ou proche du noir.

Un but de l'invention est de fournir des circuits électriques avec des contacts ou des pistes conductrices colorés, et notamment par exemple présentant une couleur noire ou proche du noir, sur au moins une partie de la surface des contacts ou pistes conductrices, tout en conservant notamment des propriétés électriques et mécaniques appropriées pour établir des connections électriques.

### Résumé de l'invention

A cet effet, il est proposé un procédé de fabrication d'un circuit électrique, notamment pour réaliser des modules de carte à puce, ce procédé comprenant les étapes suivantes :
- la fourniture d'un substrat diélectrique avec un feuillet de matériau électriquement conducteur reposant sur le substrat diélectrique,
- le dépôt d'au moins une couche d'un matériau électriquement conducteur sur le feuillet de matériau électriquement conducteur, cette couche d'un matériau électriquement conducteur formant une couche superficielle recouvrant au moins une zone de la surface d'au moins une piste conductrice, cette piste conductrice étant formée dans le feuillet de matériau électriquement conducteur.

Au cours de ce procédé, la formation de la couche superficielle comporte une étape de dépôt physique en phase vapeur à partir d'au moins une cible métallique dont au moins l'un des métaux de la liste suivante entre dans la composition : le chrome, l'hafnium, le tantale, le zirconium, le niobium, le molybdène, le vanadium, le titane et le scandium ; et dans une atmosphère comprenant au moins l'un des éléments suivants : argon, azote et oxygène. Eventuellement, cette atmosphère comprend de l'argon, de l'azote et de l'oxygène.

En effet, les inventeurs ont pu obtenir, grâce à un dépôt physique en phase vapeur de ce type, une couche superficielle ayant non seulement une couleur très sombre proche du noir, voire noire, mais également une conductivité électrique et une robustesse permettant de satisfaire aux spécifications requises notamment dans le domaine de la carte à puce et, plus particulièrement dans le domaine des cartes à puce pour les applications bancaires. D'autres couleurs ont également pu être obtenues pour la couche superficielle, grâce à un dépôt physique en phase vapeur de ce type.

Ce procédé comporte une ou plusieurs autres des caractéristiques optionnelles suivantes considérées indépendamment l'une de l'autre ou en combinaison d'une ou plusieurs autres :
- la couche superficielle est composée d'un composé du type XₚO_{q}NᵣCₛ avec X compris dans la liste constituée de Hf, Ta, Zr, Nb, Mo, Cr, V, Ti ou Sc, et où p et q sont strictement positifs et r et s sont des nombres dont au moins un est supérieur ou égal à zéro _{;}
- la couche superficielle est déposée sur une couche d'accrochage, elle-même formée à partir d'un dépôt physique en phase vapeur dans l'atmosphère d'un gaz de travail comprenant de l'argon et dans lequel est mise en oeuvre au moins une cible métallique dont au moins l'un des métaux de la liste suivante entre dans la composition : le chrome, l'hafnium, le tantale, le zirconium, le niobium, le molybdène, le vanadium, le titane et le scandium ;
- il comprend une étape de gravure par laser de la couche superficielle et de la couche d'accrochage situées entre au moins deux pistes conductrices, pour dé-court-circuiter ces pistes conductrices ;
- la couche d'accrochage et la couche superficielle sont déposées sur une grille conductrice (c'est-à-dire utilisée dans le cadre d'une technologie appelée « leadframe » en anglais) formée dans le feuillet de matériau électriquement conducteur, au cours d'étapes préalables à une étape de report de cette grille sur le substrat diélectrique ;
- la couche superficielle est déposée de manière sélective sur au moins une zone de la surface d'au moins une piste conductrice, au cours d'une étape pendant laquelle la couche superficielle préalablement déposée sur un support est reportée à l'aide d'un laser, sur le feuillet de matériau électriquement conducteur ; et
- le procédé comprend une étape de réalisation d'un masque, préalablement à la formation de la couche superficielle, pour déposer sélectivement la couche superficielle sur certaines zones seulement du feuillet de matériau électriquement conducteur ;

Selon un autre aspect, il est proposé un circuit électrique, notamment pour réaliser des modules de carte à puce. Par exemple, ce circuit électrique est réalisé grâce au procédé mentionné ci-dessus.

Ce circuit comprend :
- un substrat diélectrique avec un feuillet de matériau électriquement conducteur reposant sur le substrat diélectrique,
- au moins une couche d'un matériau électriquement conducteur reposant, directement ou non, sur le feuillet de matériau électriquement conducteur, cette couche d'un matériau électriquement conducteur formant une couche superficielle recouvrant au moins une zone de la surface d'au moins une piste conductrice, cette piste conductrice étant formée dans le feuillet de matériau électriquement conducteur.

Dans ce circuit, la couche superficielle comprend un composé du type XₚO_{q}NᵣCₛ avec X compris dans la liste constituée de Hf, Ta, Zr, Nb, Mo, Cr, V, Ti et Sc, et où p et q sont strictement positifs et r et s sont des nombres dont au moins un est supérieur ou égal à zéro.

Cette stoechiométrie de la couche permet l'obtention d'un revêtement de couleur et conducteur. La rugosité de cette couche peut également contribuer à lui apporter un aspect plus ou moins intense (notamment pour le noir), et plus ou moins mat.

En outre ce circuit peut comporter une ou plusieurs autres des caractéristiques optionnelles suivantes considérées indépendamment l'une de l'autre ou en combinaison d'une ou plusieurs autres :
- la couche superficielle comprend 30 à 65 %en poids d'au moins l'un des métaux compris dans la liste suivante : le chrome, l'hafnium, le tantale, le zirconium, le niobium, le molybdène, le vanadium, le titane et le scandium, 0 à 40 % en poids d'azote, 15 à 55 % en poids d'oxygène et 0 à 6 % en poids de carbone ;
- il comprend une couche d'accrochage, sous-jacente à la couche superficielle, cette couche d'accrochage comprenant au moins l'un des métaux de la liste suivante : le chrome, l'hafnium, le tantale, le zirconium, le niobium, le molybdène, le vanadium, le titane et le scandium ; et
- il comprend une couche d'accrochage dont l'épaisseur est comprise entre 10 et 1000 nanomètres ; par exemple l'épaisseur de la couche d'accrochage est voisine de 700 nanomètres si elle comprend essentiellement du titane ; mais la couche d'accrochage peut éventuellement avoir une épaisseur inférieure par exemple comprise entre 10 et 200 nanomètres, voire entre 10 et 100 nanomètres, et une couche superficielle dont l'épaisseur est comprise entre 100 et 2000 nanomètres, par exemple cette épaisseur est comprise entre 300 et 400 nanomètres.

### Brève description des dessins

D'autres caractéristiques, buts et avantages de l'invention mentionnée ci-dessus apparaîtront à la lecture de la description détaillée qui va suivre, et en regard des dessins annexés, donnés à titre d'exemples non limitatifs et sur lesquels :
[Fig. 1] représente schématiquement en perspective une carte à puce comportant un exemple de module selon l'invention ;
[Fig. 2] représente en coupe, schématiquement et partiellement, un exemple de connecteur pour un module de carte à puce tel que représentée sur la figure 1 ;
[Fig. 3] représente schématiquement vue de dessus une portion de circuit électrique pour un connecteur de module de carte à puce tel que représentée sur la figure 1 ;
[Fig. 4] représente schématiquement différentes étapes de plusieurs exemples de mise en oeuvre du procédé selon l'invention.

### Description détaillée

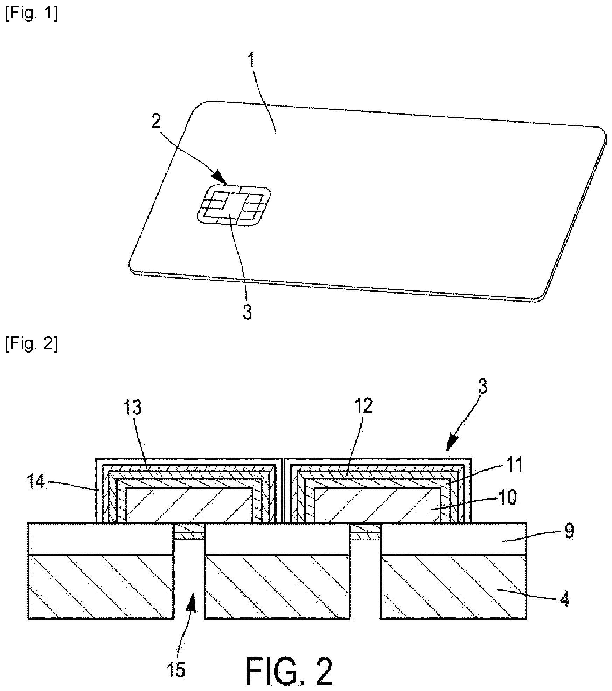

Selon un exemple d'application du circuit électrique selon l'invention, illustré par la figure 1, une carte à puce 1 comporte un module 2 avec un connecteur 3. Le module 2 est généralement réalisé sous forme d'un élément séparé qui est inséré dans une cavité ménagée dans le corps de la carte à puce 1. Cet élément comporte un substrat diélectrique 4 (voir Fig. 2) généralement flexible de PET, ou de verre-epoxy, ou de polyimide, etc. sur lequel est réalisé le connecteur 3, auquel est postérieurement connectée une puce électronique (non-représentée).

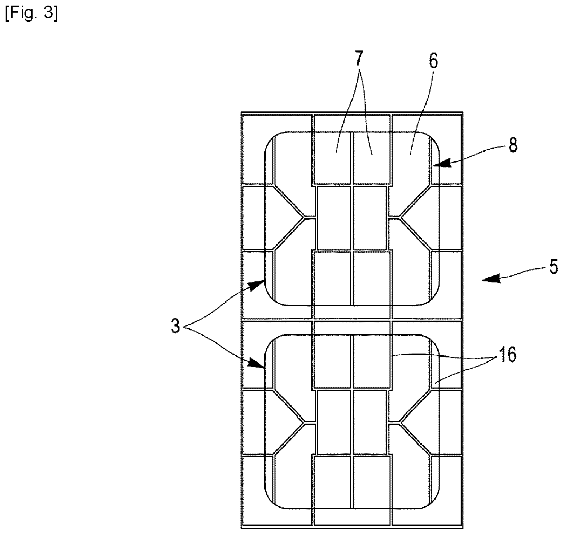

La figure 3 illustre un exemple de portion de circuit électrique 5 avec deux connecteurs 3. Chaque connecteur 3 comprend une plage de contact 8 formée de pistes conductrices 6. Dans l'exemple illustré huit contacts électriques 7 sont réalisés à partir des pistes conductrices 6, sur une face (circuit simple face). Eventuellement, d'autres pistes et/ou contacts peuvent être réalisés sur l'autre face, si le connecteur correspond à un circuit double face.

Plus particulièrement, comme représenté en coupe sur la figure 2, un connecteur 3 (c'est-à-dire essentiellement un module sans puce électronique) possède une structure multicouche formée d'un substrat diélectrique 4, d'une couche d'adhésif 9, d'un feuillet de matériau électriquement conducteur 10, d'une première couche intermédiaire 11, éventuellement d'une deuxième couche intermédiaire 12, éventuellement d'une couche d'accrochage 13 et enfin d'une couche superficielle 14.

Le substrat diélectrique 4 est par exemple formé d'un ruban de verre-époxy ayant une épaisseur de 110 micromètres. Le feuillet de matériau électriquement conducteur 10 est par exemple formé d'un feuillet de cuivre ou d'alliage de cuivre de 35 micromètres d'épaisseur. La première couche intermédiaire 11 est par exemple formée d'une couche de nickel électrodéposé de 1000 à 7000 nanomètres d'épaisseur. La deuxième couche intermédiaire 12 est par exemple formée d'une couche de palladium ou d'or électrodéposé de 1 à 300 nanomètres d'épaisseur. Plus généralement, les première et deuxième couches intermédiaires 11, 12 sont réalisées par électrodéposition par exemple et peuvent comprendre au moins l'un des métaux compris dans la liste comprenant le palladium, le cuivre, l'aluminium, le fer, l'or et le nickel.

La couche d'accrochage 13 est essentiellement composée d'une couche métallique comprenant au moins l'un des métaux suivants : le chrome, l'hafnium, le tantale, le zirconium, le niobium, le molybdène, le vanadium, le titane et le scandium. Cette couche est déposée en phase vapeur. La couche superficielle 14 est essentiellement composée d'un composé du type XₚO_{q}NᵣCₛ avec X compris dans la liste constituée de Hf, Ta, Zr, Nb, Mo, Cr, V, Ti et Sc, et où p et q sont strictement positifs et r et s sont des nombres, dont au moins un est supérieur ou égal à zéro. Cette couche est également déposée en phase vapeur, avec 30 à 65 % en poids de l'un des métaux de la liste suivante : le chrome, l'hafnium, le tantale, le zirconium, le niobium, le molybdène, le vanadium, le titane et le scandium, 0 à 40 % en poids d'azote, 15 à 55 % en poids d'oxygène et 0 à 6 % en poids de carbone. La couche d'accrochage 13 a par exemple une épaisseur comprise entre 10 et 1000 nanomètres et la couche superficielle 14 a par exemple une épaisseur comprise entre 100 et 2000 nanomètres.

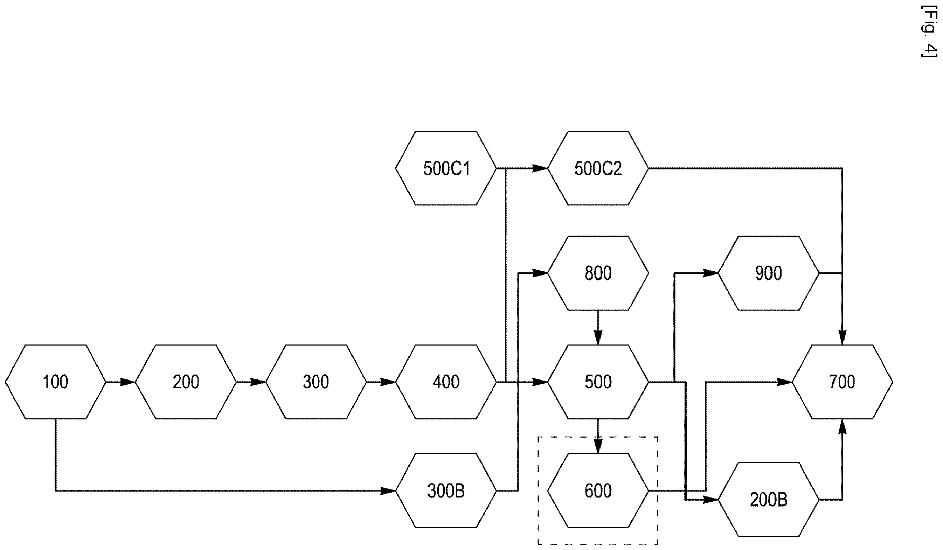

La figure 4 illustre schématiquement différentes étapes de plusieurs exemples de mise en oeuvre du procédé selon l'invention pour la fabrication du connecteur 3. Ces étapes comprennent :
- une étape 100 de fourniture d'un feuillet de matériau électriquement conducteur 10,
- une étape 200 comprenant,
   la fourniture d'un substrat 4, par exemple de verre-époxy, de PET ou de polyimide,
   l'enduction d'une face du substrat 4 avec une couche d'adhésif 9,
   la perforation du substrat 4 sur lequel repose la couche d'adhésif 9 afin de réaliser, à travers le substrat 4 et la couche d'adhésif 9, des puits de connexion 15 et éventuellement une cavité dans laquelle sera logée ultérieurement une puce électronique,
   la lamination du feuillet de matériau électriquement conducteur 10 sur le substrat 4 enduit de la couche d'adhésif 9 et recouvrant au moins en partie les puits de connexion 15 et la cavité, et éventuellement, la réticulation de la couche d'adhésif 9,
- une étape 300 de photo-lithogravure pour former des pistes conductrices 6 et/ou des contacts 7 dans le feuillet de matériau électriquement conducteur 10 ;
- une étape 400 de dépôt, par exemple par électrodéposition, de la première 11 et de l'éventuelle deuxième 12 couches intermédiaires ;
- une étape 500 de dépôt physique en phase vapeur de l'éventuelle couche d'accrochage 13 et de la couche superficielle 14 ;
- une étape 600 de gravure par laser des couches d'accrochage 13 et superficielle 14 sur des zones 16 (voir figure 3) situées entre les contacts 7 pour mettre à nu le substrat sur ces zones 16, afin de dé-courtcircuiter les pistes conductrices 6 et les contacts 7 les uns des autres ; pour cette étape, le laser a par exemple un impact (spot) de 12 à 35 micromètres de diamètre, pour une puissance de 1 à 15 Watts et un pas entre chaque impact de 0 à 60 micromètres ;
- une étape ou plusieurs étapes 700 de report de puces (par exemple une puce électronique par connecteur 3), d'individualisation des connecteurs 3, etc. à partir du circuit électrique 5 obtenu à l'issue des étapes précédentes, et menant à la réalisation d'un module 2 et/ou à la finalisation d'une carte à puce 1 comportant un tel module 2.

Alternativement, selon un autre mode de mise en oeuvre du procédé, celui-ci comporte des étapes identiques ou similaires aux étapes 100 à 500. Mais entre les étapes 400 et 500, est mise en oeuvre une étape 800 comprenant le dépôt d'un film de résine photosensible sur les couches électrodéposée 11 et 12. Cette résine est exposée à un rayonnement adapté à travers un masque, puis est révélée de manière à exposer les pistes conductrices 6 et les contacts 7 et à protéger des zones situées entre les pistes conductrices 6 et les contacts 7. Ainsi, lors de l'étape 500 de dépôt physique en phase vapeur de l'éventuelle couche d'accrochage 13 et de la couche superficielle 14, ces couches ne sont déposées que sur des zones destinées à être électriquement conductrices (pistes conductrices 6 et les contacts 7). Bien entendu, on retire ensuite au cours d'une étape 900, la résine ayant protégé les zones 16 situées entre les pistes conductrices 6 et les contacts 7, pendant l'étape 500 de dépôt physique en phase vapeur de la couche d'accrochage 13 et de la couche superficielle 14. Par exemple, pour cette étape, la solution d'attaque pourra être acide ou basique, avec une température comprise entre 15 et 50 degrés Celsius et une pression de 1 à 5 bars.

Alternativement, selon encore un autre mode de mise en oeuvre du procédé, le feuillet de matériau électriquement conducteur 10 fourni à l'étape 100 est découpé à une étape 300B pour former des pistes conductrices 6 et/ou des contacts 7 dans le feuillet de matériau électriquement conducteur 10. Autrement dit, l'étape 300B permet de réaliser une grille conductrice (aussi appelée « leadframe » en anglais). Ensuite, au cours d'une étape 500, l'éventuelle couche d'accrochage 13 et la couche superficielle 14 sont réalisées par dépôt physique en phase vapeur sur la grille conductrice. Puis, est mise en oeuvre une étape 200B comprenant la fourniture d'un substrat 4 par exemple de verre-époxy, de PET ou de polyimide, l'enduction d'une face du substrat 4 avec une couche d'adhésif 9, la perforation du substrat 4 sur lequel repose la couche d'adhésif 9 afin de réaliser, à travers le substrat 4 et la couche d'adhésif 9, des puits de connexion 15 et éventuellement une cavité dans laquelle sera logée ultérieurement une puce électronique, la lamination de la grille conductrice sur le substrat 4 enduit de la couche d'adhésif 9 et recouvrant au moins en partie les puits de connexion 15 et la cavité, et éventuellement la réticulation de la couche d'adhésif 9. La structure ainsi obtenue peut alors subir la ou les étapes 700 mentionnées ci-dessus. L'étape 600 n'est dans ce cas pas nécessaire puisque l'éventuelle couche d'accrochage 13 et la couche superficielle 14 n'ont été déposées que sur la grille conductrice et non sur le substrat 4 comme pour le premier mode de mise en oeuvre décrit précédemment. La grille peut être découpée initialement par un outil de perforation poinçon / matrice afin que les pistes conductrices 6 et les contacts 7 soient bien isolés les uns des autres.

Selon encore un autre mode de mise en oeuvre du procédé, les étapes 100 à 400 décrites ci-dessus sont mises en oeuvre. En parallèle, est mise en oeuvre une étape 500C1 de dépôt physique en phase vapeur de la couche d'accrochage 13 d'une part, ainsi que de la couche superficielle 14 d'autre part, chacune sur un support de PET par exemple. Puis, une étape 500C2 de transfert sélectif par laser est mise en oeuvre pour transférer la couche éventuelle d'accrochage 13, puis la couche superficielle 14, chacune de son support de PET sur les zones destinées à être recouvertes de la couche conductrice 14, c'est-à-dire essentiellement sur les pistes conductrices 6 et les contacts 7. Pour cette étape 500C2, le laser a un impact (spot) de 12 à 35 micromètres de diamètre, pour une puissance de 1 à 15 Watts et un pas entre deux impacts de 0 à 60 micromètres. Une étape ou plusieurs étapes 700 telles que mentionnées ci-dessus peuvent alors être ensuite mises en oeuvre pour réaliser un module 2 et/ou finaliser une carte à puce 1 comportant un tel module 2.

Le dépôt physique en phase vapeur de la couche superficielle 14 est réalisé par exemple à l'aide d'un dispositif de pulvérisation à magnétron, à courant continu, à courant continu pulsé ou en radiofréquences, avec une puissance de 100 à 700 000 Watts et une densité de courant de 10 à 200 Ampères par mètre carré. Le dépôt est effectué dans un vide ayant une pression résiduelle comprise entre 1 et 10 10⁻³ mbar.

Alternativement, ce dépôt physique en phase vapeur de la couche superficielle 14 peut être fait à l'aide d'une technique d'évaporation thermique (« thermal evaporation » en anglais) ou de dépôt physique en phase vapeur à arc cathodique (« cathodic arc physical vapor déposition » ou « CAPVD » en anglais).

Le dépôt physique en phase vapeur de la couche superficielle 14 est réalisé avec de l'argon comme gaz de travail avec un débit de 100 à 600 centimètres cubes standards par minute (« SCCM » ou « standard cubic centimeters per minute » en anglais), 10 à 150 centimètres cubes standards par minute d'azote, 1 à 100 centimètres cubes standards par minute d'oxygène et 1 à 20 centimètres cubes standards par minute d'acétylène (si le mode de dépôt du carbone utilise un gaz. Et s'il s'agit par exemple d'un dépôt visant à obtenir une couche superficielle 14 de couleur noire ou proche du noir - pour les autres couleurs, l'acétylène n'est pas toujours nécessaire).

Le dépôt physique en phase vapeur de la couche superficielle 14, que ce soit directement sur les pistes conductrices 6 et les contacts 7, ou sur un support avant report sur les pistes conductrices 6 et les contacts 7, peut aussi être réalisé à l'aide d'un procédé de dépôt physique en phase vapeur réactif en utilisant un flux d'argon comme gaz de travail ayant un débit de 40 à 70 centimètres cubes standards par minute. Pour obtenir une couche superficielle 14 de couleur noire ou proche du noir, l'ajout de carbone est effectué soit à l'aide d'une cible de graphite pulvérisée sous un flux d'argon avec un débit de 100 à 600 centimètres cubes standards par minute, soit avec un plasma de gaz acétylène ayant un débit de 1 à 20 centimètres cubes standards par minute. En outre, au cours de cette procédure de pulvérisation, un plasma est formé avec un mélange gazeux composé d'azote et d'oxygène.

Les pistes conductrices 6 ou contacts 7, avec leur couche superficielle 14 résultant de tous ces modes de mise en oeuvre, ont avantageusement une résistance de contact inférieure à 500 milli-ohms et résistent très bien aux tests de corrosion en brouillard salin tels que ceux imposés pour les cartes à puces utilisées pour les applications bancaires.

Selon des variantes des modes de mise en oeuvre du procédé décrits ci-dessus, en utilisant des masques de résine photosensible, il est possible de réaliser des motifs, tels que des logos, de couleur (à l'aide de la couche superficielle, et éventuellement de la couche d'accrochage) sur fond jaune (couche d'or sous-jacente) ou gris (couche de palladium, d'argent ou de nickel sous-jacente). De tels motifs peuvent être réalisés à des fins de personnalisation graphique ou de protection contre la copie.

### Exemples :

### Exemple 1: Dépôt noir

Un dépôt d'une couche superficielle 14 de XpOqNrCs est réalisé par dépôt physique en phase vapeur réactif (voir ci-dessus). Ce dépôt est réalisé par exemple à l'aide d'un dispositif de pulvérisation avec une puissance de 4kWatts. Ce dépôt est réalisé sur une couche d'accrochage 13 de titane d'environ 700 nanomètres (reposant elle-même sur un substrat de cuivre recouvert de nickel, puis d'or). Cette couche superficielle 14 fait 300 à 400 nanomètres environ. Le dépôt de cette couche superficielle 14 est réalisé avec de l'argon comme gaz de travail et en présence notamment de diazote, de dioxygène et de carbone. Ce dépôt est effectué dans un vide ayant une pression résiduelle voisine de 10⁻² mbar.

Les mesures par spectroscopie à dispersion d'énergie (« EDX » ou « Energy dispersive spectroscopy » en anglais), qui ne permettent pas de discriminer la composition de la couche superficielle de celle de la couche d'accrochage 13, donnent les concentrations en poids respectives : titane: 61,8% ; oxygène : 17,5% ; azote : 16,7% et carbone : 4.0%.

La résistance de contact obtenue est inférieure à 500 milli-ohms avant et après un test de brouillard salin de 24h suivant la norme ISO9227.

La couche superficielle 14 résultant de ce mode de mise en oeuvre, a une colorimétrie avec un indice L* inférieur à 40 dans l'espace chromatique CIELAB introduit par l'organisation IEC (International Commission on Illumination). De même, les indices a* et b* dans cet espace chromatique sont proches de zéro et inférieurs à 5 en valeur absolue.

### Exemple 2: Dépôt vert ou bleu

Un dépôt d'une couche superficielle 14 de XpOqNrCs est réalisé par PVD (« physical vapor déposition » en anglais, pour « dépôt physique en phase vapeur »). Ce dépôt est réalisé par exemple à l'aide d'un dispositif de pulvérisation (de type magnétron) avec une puissance de 20kWatts. Ce dépôt est réalisé sans sous-couche d'accrochage 13 de titane. La couche superficielle 14 repose donc directement sur un substrat de cuivre recouvert de nickel, puis d'or. Cette couche superficielle 14 fait 50 à 100 nanomètres environ. Le dépôt de cette couche superficielle 14 est réalisé avec de l'argon comme gaz de travail et en présence de diazote et de dioxygène. Ce dépôt est effectué dans un vide ayant une pression résiduelle voisine de 4.10⁻³ mbar.

Les mesures par spectroscopie à dispersion d'énergie donnent les concentrations en poids respectives :
a) pour le vert : titane : 62% ; oxygène : 38% ; azote : présent sous formes de traces.
b) pour le bleu : titane : 51 % ; oxygène : 49% ; azote : présent sous formes de traces.

La résistance de contact obtenue dans tous ces cas est inférieure à 500 milli-ohms.

## Revendications

1. Circuit électrique comportant des contacts électriques, notamment pour réaliser des modules de carte à puce, comprenant :
- un substrat diélectrique (4) avec un feuillet de matériau électriquement conducteur (10) reposant sur le substrat diélectrique (4),
- au moins une couche d'un matériau électriquement conducteur (14) reposant, directement ou non, sur le feuillet de matériau électriquement conducteur (10), cette couche d'un matériau électriquement conducteur (14) formant une couche superficielle recouvrant au moins une zone de la surface d'au moins piste conductrice (6), cette piste conductrice (6) étant formée dans le feuillet de matériau électriquement conducteur (10) et étant configurée pour former les contacts électriques,
**caractérisé par le fait que** la couche superficielle (14) comprend un composé du type XₚO_{q}NᵣCₛ avec X compris dans la liste constituée de Hf, Ta, Zr, Nb, Mo, Cr, V, Ti et Sc, et où p et q sont strictement positifs et r et s sont des nombres, dont au moins un est supérieur ou égal à zéro.

2. Circuit électrique selon la revendication 1, dans lequel la couche superficielle (14) comprend 30 à 65 % en poids d'au moins l'un des métaux compris dans la liste constituée de Hf, Ta, Zr, Nb, Mo, Cr, V, Ti ou Sc, 0 à 40 % en poids d'azote, 15 à 55 % en poids de d'oxygène et 0 à 6 % en poids de carbone.

3. Circuit électrique selon la revendication 1 ou 2, comprenant une couche d'accrochage (13), sous-jacente à la couche superficielle (14), cette couche d'accrochage (13) comprenant au moins l'un des métaux de la liste suivante : le chrome, l'hafnium, le tantale, le zirconium, le niobium, le molybdène, le vanadium, le titane et le scandium.

4. Circuit électrique selon la revendication 3, comprenant une couche d'accrochage (13) dont l'épaisseur est comprise entre 10 et 1000 nanomètres et une couche superficielle (14) dont l'épaisseur est comprise entre 100 et 2000 nanomètres.

5. Circuit électrique selon l'une des revendications 1 à 4, dans lequel X =Ti.

6. Carte à puce comprenant un corps de carte et un module (2) inséré dans une cavité ménagée dans le corps de carte, ce module (2) comprenant un connecteur (3) comprenant un circuit électrique selon l'une des revendications précédentes.

7. Procédé de fabrication spécialement conçu pour la fabrication d'un circuit électrique selon l'une des revendications 1 à 5, ce procédé comprenant les étapes suivantes :
- la fourniture d'un substrat diélectrique (4) avec un feuillet de matériau électriquement conducteur (10) reposant sur le substrat diélectrique (4),
- le dépôt d'au moins une couche d'un matériau électriquement conducteur (14) sur le feuillet de matériau électriquement conducteur (10), cette couche d'un matériau électriquement conducteur (14) formant une couche superficielle (14) recouvrant au moins une zone de la surface d'au moins une piste conductrice (6), cette piste conductrice (6) étant formée dans le feuillet de matériau électriquement conducteur (10) et étant configurée pour former les contacts électriques,
**caractérisé par le fait que** la formation de la couche superficielle (14) comporte une étape de dépôt physique en phase vapeur à partir d'au moins une cible métallique dont au moins l'un des métaux de la liste suivante entre dans la composition : le chrome, l'hafnium, le tantale, le zirconium, le niobium, le molybdène, le vanadium, le titane et le scandium, et dans l'atmosphère d'un gaz comprenant au moins l'un des éléments suivants : argon, azote et oxygène et dans lequel la couche superficielle (14) comprend un composé du type XpOqNrCsavec X compris dans la liste constituée de Hf, Ta, Zr, Nb, Mo, Cr, V, Ti et Sc, et où p, q et r sont des entiers strictement positifs et s est un entier positif supérieur ou égal à zéro.

8. Procédé selon la revendication 7, dans lequel la couche superficielle (14) est déposée sur une couche d'accrochage (13), elle-même formée à partir d'un dépôt physique en phase vapeur dans l'atmosphère d'un gaz de travail comprenant de l'argon et dans lequel est mise en oeuvre au moins une cible métallique dont au moins l'un des métaux de la liste suivante entre dans la composition : le chrome, l'hafnium, le tantale, le zirconium, le niobium, le molybdène, le vanadium, le titane et le scandium .

9. Procédé selon la revendication 8 comprenant une étape de gravure par laser de la couche superficielle (14) et la couche d'accrochage (13) situées entre au moins deux pistes conductrices (6), pour dé-courtcircuiter ces pistes conductrices (6).

10. Procédé selon la revendication 8, dans lequel la couche d'accrochage (13) et la couche superficielle (14) sont déposées sur une grille conductrice formée dans le feuillet de matériau électriquement conducteur (10), au cours d'étapes préalables à une étape de report de cette grille sur le substrat diélectrique (4)

11. Procédé selon l'une des revendication 7 à 8, dans lequel la couche superficielle (14) est déposée de manière sélective sur au moins une zone de la surface d'au moins une piste conductrice (6), au cours d'une étape pendant laquelle la couche superficielle (14) préalablement déposée sur un support est reportée à l'aide d'un laser, sur le feuillet de matériau électriquement conducteur (10).

12. Procédé selon l'une des revendications 7 à 11, comprenant une étape (800) de réalisation d'un masque, préalablement à la formation de la couche superficielle (14), pour déposer sélectivement la couche superficielle (14) sur certaines zones seulement du feuillet de matériau électriquement conducteur (10).

## Patentansprüche

1. Elektrischer Schaltkreis mit elektrischen Kontakten, insbesondere zur Herstellung von Chipkartenmodulen, mit:
- ein dielektrisches Substrat (4) mit einem Blatt aus elektrisch leitendem Material (10), das auf dem dielektrischen Substrat (4) liegt,
- mindestens eine Schicht aus einem elektrisch leitenden Material (14), die direkt oder nicht direkt auf dem Blatt aus elektrisch leitendem Material (10) liegt, wobei die Schicht aus einem elektrisch leitenden Material (14) eine Oberflächenschicht bildet, die mindestens einen Bereich der Oberfläche von mindestens einer Leiterbahn (6) bedeckt, wobei die Leiterbahn (6) in dem Blatt aus elektrisch leitendem Material (10) ausgebildet ist und so konfiguriert ist, dass sie die elektrischen Kontakte bildet,
**dadurch gekennzeichnet, dass** die Oberflächenschicht (14) eine Verbindung des Typs XₚO_{q}NᵣCₛ umfasst, wobei X in der aus Hf, Ta, Zr, Nb, Mo, Cr, V, Ti und Sc bestehenden Liste enthalten ist und wobei p und q streng positiv sind und r und s Zahlen sind, von denen mindestens eine größer als oder gleich Null ist.

2. Elektrischer Schaltkreis nach Anspruch 1, wobei die Oberflächenschicht (14) 30 bis 65 Gew.-% mindestens eines der Metalle aus der Liste bestehend aus Hf, Ta, Zr, Nb, Mo, Cr, V, Ti oder Sc, 0 bis 40 Gew.-% Stickstoff, 15 bis 55 Gew.-% Sauerstoff und 0 bis 6 Gew.-% Kohlenstoff umfasst.

3. Elektrische Schaltung nach Anspruch 1 oder 2, die eine unter der Oberflächenschicht (14) liegende Haftschicht (13) umfasst, wobei die Haftschicht (13) mindestens eines der Metalle aus der folgenden Liste umfasst: Chrom, Hafnium, Tantal, Zirkonium, Niob, Molybdän, Vanadium, Titan und Scandium.

4. Elektrische Schaltung nach Anspruch 3, die eine Haftschicht (13) mit einer Dicke zwischen 10 und 1000 Nanometern und eine Oberflächenschicht (14) mit einer Dicke zwischen 100 und 2000 Nanometern umfasst.

5. Elektrischer Schaltkreis nach einem der Ansprüche 1 bis 4, wobei X =Ti.

6. Chipkarte mit einem Kartenkörper und einem Modul (2), das in einen Hohlraum im Kartenkörper eingesetzt ist, wobei das Modul (2) einen Verbinder (3) mit einer elektrischen Schaltung nach einem der vorhergehenden Ansprüche aufweist.

7. Herstellungsverfahren, das speziell für die Herstellung einer elektrischen Schaltung nach einem der Ansprüche 1 bis 5 ausgelegt ist, wobei das Verfahren die folgenden Schritte umfasst:
- Bereitstellung eines dielektrischen Substrats (4) mit einem Blatt aus elektrisch leitendem Material (10), das auf dem dielektrischen Substrat (4) liegt,
- Abscheiden mindestens einer Schicht aus einem elektrisch leitenden Material (14) auf dem Blatt aus elektrisch leitendem Material (10), wobei die Schicht aus einem elektrisch leitenden Material (14) eine Oberflächenschicht (14) bildet, die mindestens einen Bereich der Oberfläche mindestens einer Leiterbahn (6) bedeckt, wobei die Leiterbahn (6) in dem Blatt aus elektrisch leitendem Material (10) ausgebildet ist und so konfiguriert ist, dass sie die elektrischen Kontakte bildet,
**dadurch gekennzeichnet, dass** die Bildung der Oberflächenschicht (14) einen Schritt der physikalischen Dampfabscheidung aus mindestens einem metallischen Target umfasst, von dem mindestens eines der Metalle aus der folgenden Liste in der Zusammensetzung enthalten ist: Chrom, Hafnium, Tantal, Zirkonium, Niob, Molybdän, Vanadium, Titan und Scandium, und in der Atmosphäre eines Gases, das mindestens eines der folgenden Elemente enthält: Argon, Stickstoff und Sauerstoff und wobei die Oberflächenschicht (14) eine Verbindung des Typs XₚO_{q}NᵣCₛ umfasst, wobei X in der aus Hf, Ta, Zr, Nb, Mo, Cr, V, Ti und Sc bestehenden Liste enthalten ist und wobei p und q streng positiv sind und r und s Zahlen sind, von denen mindestens eine größer als oder gleich Null ist.

8. Verfahren nach Anspruch 7, bei dem die Oberflächenschicht (14) auf einer Haftschicht (13) abgeschieden wird, die ihrerseits aus einer physikalischen Dampfabscheidung in der Atmosphäre eines Arbeitsgases, das Argon enthält, gebildet wird, und bei dem mindestens ein metallisches Target eingesetzt wird, von dem mindestens eines der Metalle aus der folgenden Liste in die Zusammensetzung eingeht: Chrom, Hafnium, Tantal, Zirkonium, Niob, Molybdän, Vanadium, Titan und Scandium.

9. Verfahren nach Anspruch 8 mit einem Schritt des Laserätzens der Oberflächenschicht (14) und der Haftschicht (13), die sich zwischen mindestens zwei Leiterbahnen (6) befinden, um diese Leiterbahnen (6) kurzzuschließen.

10. Verfahren nach Anspruch 8, bei dem die Haftschicht (13) und die Oberflächenschicht (14) auf einem leitenden Gitter abgeschieden werden, das in dem Blatt aus elektrisch leitendem Material (10) gebildet wird, und zwar in Schritten vor einem Schritt des Übertragens dieses Gitters auf das dielektrische Substrat (4).

11. Verfahren nach einem der Ansprüche 7 bis 8, bei dem die Oberflächenschicht (14) selektiv auf mindestens einem Bereich der Oberfläche mindestens einer Leiterbahn (6) in einem Schritt aufgebracht wird, in dem die zuvor auf einem Träger aufgebrachte Oberflächenschicht (14) mit Hilfe eines Lasers auf das Blatt aus elektrisch leitfähigem Material (10) übertragen wird.

12. Verfahren nach einem der Ansprüche 7 bis 11, mit einem Schritt (800), bei dem vor der Bildung der Oberflächenschicht (14) eine Maske hergestellt wird, um die Oberflächenschicht (14) selektiv nur auf bestimmten Bereichen des Blattes aus elektrisch leitendem Material (10) abzuscheiden.

## Claims

1. Electrical circuit having electrical contacts, in particular for producing chip card modules, comprising:
- a dielectric substrate (4) with a sheet of electrically conductive material (10) lying on the dielectric substrate (4),
- at least one layer of electrically conductive material (14) lying directly or indirectly on the sheet of electrically conductive material (10), this layer of electrically conductive material (14) forming a surface layer covering at least one region of the surface of at least one conductor track (6), this conductor track (6) being formed in the sheet of electrically conductive material (10) and being configured to form the electrical contacts,
**characterised in that** the surface layer (14) comprises a compound of the type XₚO_{q}NᵣCₛ with X included in the list consisting of Hf, Ta, Zr, Nb, Mo, Cr, V, Ti and Sc, and where p and q are strictly positive and r and s are numbers, at least one of which is greater than or equal to zero.

2. An electrical circuit according to claim 1, wherein the surface layer (14) comprises 30 to 65% by weight of at least one of the metals included in the list consisting of Hf, Ta, Zr, Nb, Mo, Cr, V, Ti or Sc, 0 to 40% by weight of nitrogen, 15 to 55% by weight of oxygen and 0 to 6% by weight of carbon.

3. Electrical circuit according to claim 1 or 2, comprising a bonding layer (13) underlying the surface layer (14), this bonding layer (13) comprising at least one of the metals from the following list: chromium, hafnium, tantalum, zirconium, niobium, molybdenum, vanadium, titanium and scandium.

4. Electrical circuit according to claim 3, comprising a bonding layer (13) with a thickness of between 10 and 1000 nanometres and a surface layer (14) with a thickness of between 100 and 2000 nanometres.

5. An electrical circuit according to one of claims 1 to 4, wherein X =Ti.

6. A smart card comprising a card body and a module (2) inserted in a cavity formed in the card body, this module (2) comprising a connector (3) comprising an electrical circuit according to one of the preceding claims.

7. A manufacturing method specially designed for manufacturing an electrical circuit according to one of claims 1 to 5, said method comprising the following steps:
- providing a dielectric substrate (4) with a sheet of electrically conductive material (10) lying on the dielectric substrate (4),
- depositing at least one layer of electrically conductive material (14) on the sheet of electrically conductive material (10), this layer of electrically conductive material (14) forming a surface layer (14) covering at least one area of the surface of at least one conductor track (6), this conductor track (6) being formed in the sheet of electrically conductive material (10) and being configured to form the electrical contacts,
**characterized in that** the formation of the surface layer (14) comprises a step of physical vapour deposition from at least one metal target in which at least one of the metals on the following list is included in the composition: chromium, hafnium, tantalum, zirconium, niobium, molybdenum, vanadium, titanium and scandium, and in the atmosphere of a gas comprising at least one of the following elements: argon, nitrogen and oxygen, and in which the surface layer (14) comprises a compound of the type XₚO_{q}NᵣCₛ with X included in the list consisting of Hf, Ta, Zr, Nb, Mo, Cr, V, Ti and Sc, and where p and q are strictly positive and r and s are numbers at least one of which is greater than or equal to zero.

8. Process according to claim 7, in which the surface layer (14) is deposited on an bonding layer (13), itself formed from a physical vapour deposition in the atmosphere of a working gas comprising argon and in which at least one metal target is used, at least one of the metals from the following list being included in the composition: chromium, hafnium, tantalum, zirconium, niobium, molybdenum, vanadium, titanium and scandium.

9. Process according to claim 8 comprising a step of laser etching of the surface layer (14) and the bonding layer (13) located between at least two conductive tracks (6), in order to de-short-circuit these conductive tracks (6).

10. Process according to claim 8, in which the bonding layer (13) and the surface layer (14) are deposited on a conductive grid formed in the sheet of electrically conductive material (10), during steps prior to a step of transferring this grid to the dielectric substrate (4).

11. Process according to one of claims 7 to 8, in which the surface layer (14) is selectively deposited on at least one area of the surface of at least one conductive track (6), during a step in which the surface layer (14) previously deposited on a support is transferred, using a laser, to the sheet of electrically conductive material (10).

12. Method according to one of claims 7 to 11, comprising a step (800) of producing a mask, prior to the formation of the surface layer (14), in order selectively to deposit the surface layer (14) on certain zones only of the sheet of electrically conductive material (10).
